# EUROPEAN PATENT APPLICATION

(11) **EP 0 707 392 A2**
(43) Date of publication of application: **17.04.1996**
(21) Application number: 95307192.5
(22) Date of filing: 11.10.1995
(51) Int. Cl.: H04B 10/10, H03M 9/00

(54) **Low power gigabaud link module**

(30) Priority: 12.10.1994 US 322072
(71) Applicant: METHODE ELECTRONICS, Inc., Chicago, Illinois 60656-4549 (US)
(72) Inventor: Gilliland, Patrick, Chicago, Illinois (US); McGinley, James W., Schaumburg, Illinois (US)
(74) Representative: MacGregor, Gordon

(57) **Abstract**

A low power gigabaud link module for performing bidirectional data transfers between a parallel data bus and a serial data link. The module contains a switching voltage regulator for converting a five volt source input, which is supplied by the bus, into a low voltage output of 3.3 volts. The 3.3 volt output supplies both a parallel-to-serial data converter and a serial-to-parallel data converter which are used for bi-directionally transferring data. In addition, the regulator is shielded and mounted on the module in such a manner that any electromagnetic noise generated by the regulator will not interfere with data transfers.

## Description

### Field of the Invention

This invention relates generally to gigabaud link module devices and in particular, it relates to a module containing its own voltage converter for providing power to semiconductors which operate at a low voltage level.

Gigabaud link modules are defined by the Gigabaud Link Module Specification (FCSI-301, Revision 1.0). Theses modules provide a bi-directional interface between a parallel format data transfer medium and a serial format data transfer medium. In addition, these modules have common footprints for a variety of speeds, media types and lengths, and interface widths.

In conducting a transfer of data from a parallel format to a serial format, a gigabaud link module accepts parallel encoded data from an electrical interface consisting of a bus. The module transforms the parallel encoded data into a serial format which is transmitted over a data link. Likewise, in conducting a transfer of data from a serial format to a parallel format, the module receives serially encoded data from the data link which is deserialized and transmitted as parallel encoded data onto the bus.

Gigabaud link modules are used primarily in Fibre Channel applications, but the modules can also be used in other data transmission applications. However, all modules are designed to comply with the ANSI X3T11 Fiber Channel Physical (FC-PH) Draft Standard, Revision 4.2.

One problem encountered with the use of gigabaud link modules is their need for a large amount of power. As stated in the Gigabaud Link Module Specification, these modules only receive five volt power from the bus and, for a module which supports a transfer speed of 1063 Mbaud, 950 milliamps of current is typically required. Thus, a 1063 Mbaud module will consume an average of 4.75 watts of power. A major portion of this power, typically 4 watts, is required by the parallel-to-serial and serial-to-parallel conversion chipsets.

Dissipating this much power causes two primary problems. First, the high power consumption results in the generation of localized heating in the vicinity of the module. The negative impact of excessive heating and high temperatures on the reliability of computers and other electronic equipment is very well documented. Second, additional capacity must also be provided by the equipment power supply which supplies power to all modules. This increase in power supply size and weight comes at a significant cost penalty.

Therefore, there is a need for a module which consumes less power. The present invention is such an apparatus.

In view of the above, it is an object of the invention to provide a module which operates under low power conditions.

It is another object of the present invention to provide a module which dissipates very little heat.

Also, it is another object of the present invention to increase the sensitivity of the module's serially encoded data receiver.

It is still another object of the present invention to provide a module with high reliability.

Furthermore, it is an object of the present invention to provide a module which can be manufactured at low cost.

### Summary of the Invention

In one form of the invention, a low power gigabaud link module performs bi-directional data transfers between a parallel data bus and a serial data link. The module converts a five volt source input, which is supplied by the bus, into a low voltage output which is less than five volts. The low voltage output is utilized in the bi-directional data transfers between the parallel data bus and the serial data link. The transfer means includes a parallel-to-serial data converter and/or a serial-to-parallel data converter. The voltage converter means includes a switching voltage regulator. The switching regulator in an embodiment generates an output voltage of 3.3 volts which can vary by 10 percent.

In an embodiment, the present invention further provides for the prevention of electromagnetic noise, as a result of converting the five volt source input, from interfering with the bi-directional data transfers between the parallel data bus and the serial data link. The electromagnetic noise prevention means comprises mounting the voltage converter means away from noise sensitive components mounted on the module and/or a electromagnetic shield, made of conductive material, connected to ground, and surrounding the voltage converter means.

In another form of the invention, a module is provided for performing transfers between a parallel data bus and a serial data link. The module receives an input voltage which is converted into an output voltage which is below that of the input voltage. The output voltage is utilized in the performance of the transfers between the parallel data bus and the serial data link.

In another form of the invention, a method of performing low power gigabaud link module bi-directional data transfers is provided between a parallel data bus, which contains a voltage input, and a serial data link. The method of performing the data transfers is accomplished by converting the voltage input into a low voltage output which is less than the bus voltage input. In addition, the data transfers between the parallel data bus and the serial data link are performed by utilizing the low voltage output.

In an embodiment, the method further provides for the preventing of electromagnetic noise from interfering with the data transfers between the parallel data bus and the serial data link.

Various means for practicing the invention and other advantages and novel features thereof will be apparent from the following detailed description of an illustrative preferred embodiment of the invention.

### Brief Description of the Drawings

There is shown in the drawings a presently preferred embodiment of the present invention, wherein like numerals in the various figures pertain to like elements, and wherein:
FIG. 1 is a functional block diagram of a low power optical link module; and
FIG. 2 is a layout for the low power optical link module.
FIG. 3 is a perspective view of a low power optical link module with a cut-away of the electromagnetic shielding.

### Detailed Description of the Preferred Embodiments

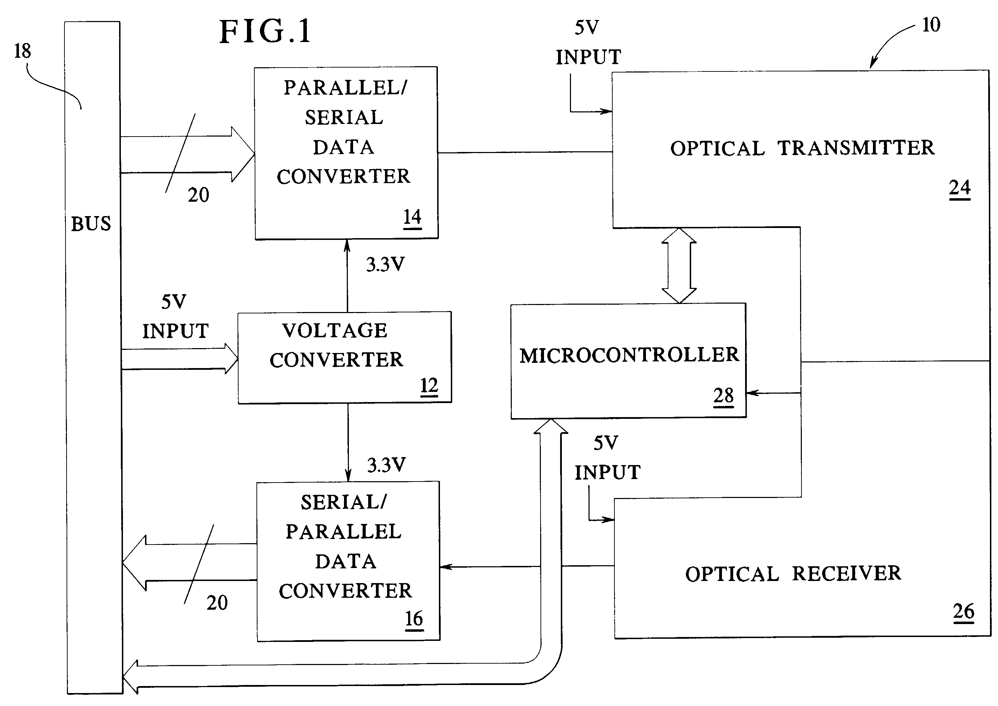

Referring to the drawings, and particularly to FIG. 1, a functional block diagram of a low power optical link module 10 is depicted with a voltage converter 12, a parallel-to-serial data converter 14, and a serial-to-parallel data converter 16.

Although an optical link module is depicted in the presently preferred embodiment, it should be understood from the outset that this invention can be used for any member of the family of gigabaud link modules as defined in the Gigabaud Link Module Specification. For example, this invention can be used on those modules supporting different types of media such as long wave laser, short wave laser, Light Emitting Diode (LED), or copper and those modules operating at different speeds such as 531 Mbaud and 266 Mbaud.

In FIG. 1, the low power optical link module 10 receives and transmits parallel formatted data over an electrical bus 18. In addition, the module 10 transmits and receives data over a serial interface consisting of a fiber optic cable (not shown). The data transmission conforms to the requirements of ANSI X3T11 Fiber Channel. However, the invention is applicable to modules which support other data transmission standards.

In the currently preferred embodiment, the input to the voltage converter 12 is connected to a five volt source provided by the bus 18. As stated in the Gigabaud Link Module Specification, the five volt source input can vary by ten percent. The five volt source input is transformed by the voltage converter 12 into an output voltage of 3.3 volts.

The type of voltage converter 12 currently preferred is a switching voltage regulator because of its low power requirement for converting five volts to 3.3 volts. In addition, the amount of heat generated by a switching voltage regulator is less than that generated by a linear regulator. A switching voltage regulator with an efficiency greater than 85% is easily achievable using today's technology. For example, Maxim Integrated Products' MAX748A converter is a suitable component for use as the voltage converter 12. Maxim's converter requires only four external components: an inductor, two filter capacitors, and a rectifier diode.

The output of the voltage converter 12 is used to supply 3.3 volts to both the parallel-to-serial converter 14 and the serial-to-parallel converter 16. In the presently preferred embodiment, Vitesse Semiconductor Corporation's VSC7105 is used to perform the parallel-to-serial conversion. The VSC7105 operates at a lower power and generates less heat than those parallel-to-serial converters requiring an input voltage of five volts. The VSC7105 also provides for multiplication of the system clock in order to perform the data conversion at the desired baud rate. Similarly, Vitesse Semiconductor Corporation's VSC7106 is used to perform the serial-to-parallel conversion. The VSC7106 also operates at a lower power and generates less heat than those serial-to-parallel converters requiring an input voltage of five volts. The VSC7106 also provides for recovery of the clock from the serial data transfer. Furthermore, both the parallel-to-serial converter 14 and the serial-to-parallel converter 16 are ANSI X3T11 Fiber Channel compatible.

The power savings by using Vitesse Semiconductor Corporation's VSC7105 and VSC7106 is substantial. For example, Hewlett-Packard Company's Fibre Channel Transmitter and Receiver Chipset, comprised of a HDMP-1512 Transmitter and a HDMP-1514 Receiver, consume a maximum of 875 mA at five volts (i.e., 4.375 W). Conversely, Vitesse Semiconductor Corporation's VSC7105 and VSC7106 consume a maximum of only 870 mA at 3.3 volts (i.e., 2.87 W). This 1.5 watt difference, assuming only 85% efficiency in the voltage converter, translates to a net savings of over 1.2 watts. Therefore, the penalty of 10% to 15% due to the voltage converter is easily overcome by the 50% to 60% reduction in power dissipation of the parallel/serial and serial/parallel conversion circuits due to their lower voltage supply requirement.

As stated previously, the input to the parallel-to-serial converter 14 is connected to the bus 18. Although the parallel-to-serial converter 14 in FIG. 1 is shown to be connected to twenty data lines from the bus 18, it should be understood that a module utilizing a different number of data lines can also be utilized.

The serial data output of the parallel-to-serial converter 14 is connected to an optical transmitter 24 having its output connected to an optical fiber (optical fiber not shown). The optical transmitter 24 is powered by the five volt source input provided by the bus 18. During operation, the parallel-to-serial converter 14 receives data, in a parallel format, from the bus 18 which is then converted into a serial format and transmitted to the optical transmitter 24 for transmission over the optical fiber.

Likewise, the input of an optical receiver 26 is connected to an optical fiber (not shown). The serial output of the optical receiver 26 is connected to the data input of the serial-to-parallel converter 16 which has its output connected to the bus 18. The optical receiver 26 is powered by the five volt source input provided by the bus 18. During operation, the optical receiver 26 receives data in a serial format from the optical fiber. The optical receiver 26 transmits the serial data to the serial-to-parallel converter 16 where the data is converted into a parallel format and transmitted onto the bus 18.

It should be noted that the use of the lower voltage supply for the parallel data transfers has the desired effect of reducing switching transient noise coupled into the highly sensitive optical receiver 26 via the five volt source input from the bus 18. This decoupling can have the very beneficial effect of increasing the receiver's sensitivity to low level optical signals.

Connected to the optical transmitter 24, the optical receiver 26, and the bus 18 is a microcontroller 28. The microcontroller 28 regulates the timing and maintains the interface between the various components, the bus 18, and the optical fibers.

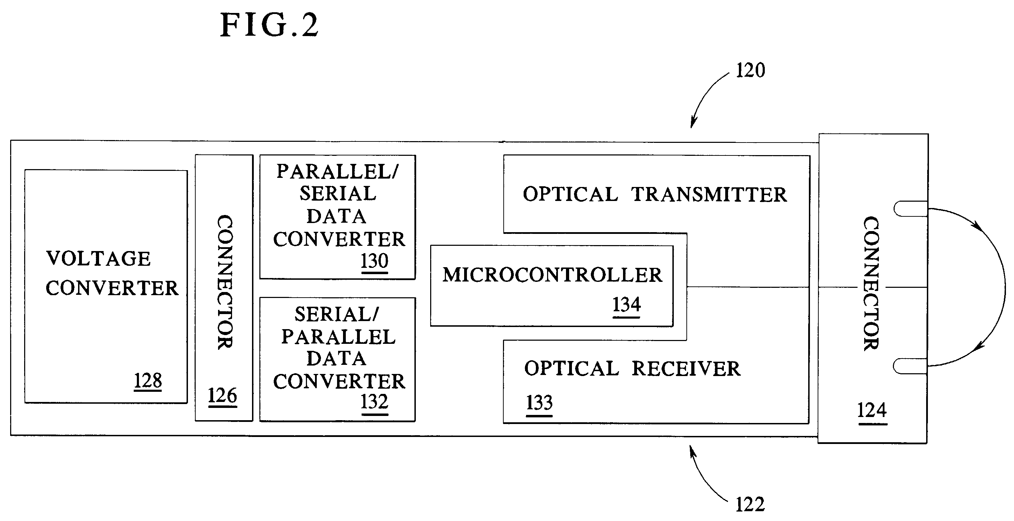

Turning to FIG. 2, a layout for the low power optical link module 120 is depicted. As stated previously, the Gigabaud Link Module Specification determines the envelope of the module 120. On the first end 122 of the module 120, an optical connector 124 is mounted corresponding to the requirements of the Gigabaud Link Module Specification. Correspondingly, as also specified by the Gigabaud Link Module Specification, an 80 pin connector 126 is mounted on the module 120 at a specific distance from the optical connector 124. Although the location of the connectors and several other features of the module 120 are specified, the placing of electrical components is not specified by the Gigabaud Link Module Specification.

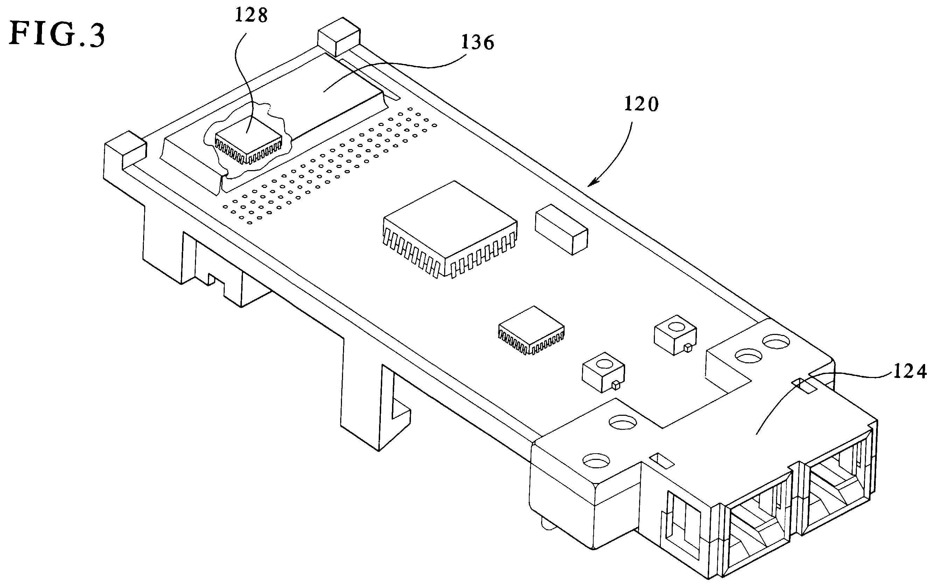

As also stated previously, in the presently preferred embodiment, a voltage converter 128 is used to convert the five volt source input provided by the bus into 3.3 volts. The use of the voltage converter 128 results in electromagnetic noise which can interfere with the operation of the parallel-to-serial converter 130, the serial-to-parallel converter 132, the optical receiver 133, the microcontroller 134, or any other logic which is mounted to the module 120. In order to reduce the electromagnetic noise emanated from the voltage converter 128 and especially the inductor (not shown) which is connected to the voltage converter, it is preferred that the voltage converter 128 and its inductor be positioned away from the other elements of the module 120. For example, in FIG. 3, the voltage converter 128 is placed on the opposite end of the module 120 from where the optical connector 124 is mounted. In addition, in another embodiment, the voltage converter 128 can also be placed on the opposite side of the module 120 from where noise susceptible components are mounted.

In addition, to further reduce the effect of noise emanating from the voltage converter 128 and its inductor, electromagnetic shielding 136 may be provided in order to protect noise sensitive components such as digital logic from interference. In the presently preferred embodiment, the shielding 136 surrounds the voltage converter 128 and its inductor and the shielding is made of conductive metallic material which is connected to a ground provided by the bus.

For completeness in the disclosure of the above-described module, but not for purpose of limitation, the above component identifications were submitted. Those components were employed in a 1063 Mbaud optical link module that was constructed and tested and which provides a high quality performance. Those skilled in the art will recognize that many alternative elements and values may be employed in constructing the circuity in accordance with the present invention.

It should be understood that various changes and modifications to the presently preferred embodiments described herein will be apparent to those skilled in the art. Such changes and modifications may be made without departing from the spirit and scope of the present invention and without diminishing its attendant advantages. It is, therefore, intended that such changes and modifications be covered by the appended claims.

## Claims

1. A low power gigabaud link module for performing bi-directional data transfers between a parallel data bus and an optical serial data link, said bus providing a five volt source input and said low power gigabaud link module comprising:
a) means for converting said five volt source input into a low voltage output which is less than that of said five volt source input; and
b) means for providing said bi-directional data transfers by utilizing said low voltage output in order to conserve power.

2. A module for performing transfers between a parallel data bus and an optical serial data link, said module receiving an input voltage and said module comprising:
a) means for converting said input voltage into a converted output voltage which is below that of said input voltage; and
b) means for utilizing said converted output voltage to perform said transfers and conserve power.

3. The module of claim 1 or 2, wherein said utilization means includes a parallel-to-serial data converter connected to said output voltage.

4. The module of claim 1 or 2, wherein said utilization means includes a serial-to-parallel data converter connected to said output voltage.

5. The module of claim 1 or 2, wherein said voltage conversion means comprises a switching voltage regulator.

6. The module of claim 5, wherein said switching regulator generates an output voltage of 3.3 volts which can vary by ten percent.

7. The module of claim 6, wherein said utilization means includes:
a) a parallel-to-serial data converter connected to said 3.3 voltage output; and
b) a serial-to-parallel data converter connected to said 3.3 voltage output.

8. The module of any preceding claim further comprising:
means for preventing electromagnetic noise generated by said voltage conversion means from interfering with said transfers.

9. The module of claim 8, wherein said electromagnetic noise prevention means comprises mounting said voltage conversion means away from noise sensitive components mounted on said module.

10. The module of claim 8, wherein said electromagnetic noise prevention means comprises an electromagnetic shield made of conductive material, connected to ground, and surrounding said voltage conversion means.

11. The module of any preceding claim further comprising:
a) an optical receiver for transmitting serial data from said serial data link to said utilization means; and
b) means for isolating said optical receiver from effects of direct coupled switching transients.

12. The module of claim 11, wherein said isolation means is capable of powering said optical receiver by said input voltage.

13. A method for performing low power gigabaud link module bi-directional data transfers between a parallel data bus and an optical serial data link, said bus providing a voltage input and said method of performing transfers comprising the steps of:
a) converting said voltage input into a low voltage output which is less than said voltage input; and
b) performing said data transfers while utilizing said low voltage output in order to conserve power.

14. The method of claim 13, which further comprises the step of:
preventing electromagnetic noise from interfering with said data transfers.
